# FASCICULE DE BREVET EUROPEEN

(11) **EP 2 912 689 B1**
(45) Date de publication et mention de la délivrance du brevet: **26.04.2017**
(21) Numéro de dépôt: 13795550.6
(22) Date de dépôt: 22.10.2013
(51) Int. Cl.: H01L 27/142

(54) **PROCÉDÉ DE FABRICATION D'UN DISPOSITIF PHOTOVOLTAÏQUE A COUCHES MINCES, NOTAMMENT POUR VITRAGE SOLAIRE**
VERFAHREN ZUR HERSTELLUNG EINES FOTOVOLTAISCHEN DÜNNSCHICHT-BAUELEMENTS, INSBESONDERE FÜR SOLARE VERGLASUNG
METHOD FOR PRODUCING A THIN-FILM PHOTOVOLTAIC DEVICE, IN PARTICULAR FOR SOLAR GLAZING

(30) Priorité: 23.10.2012 FR 1260068
(43) Date de publication de la demande: 02.09.2015
(73) Titulaire: Crosslux, 13790 Rousset (FR)
(72) Inventeur: RICCI, Marc, F-13009 Marseille (FR); THOULON, Pierre-Yves, F-13100 Le Tholonet (FR); JAGER, Ivan, F-13100 Aix en Provence (FR)
(74) Mandataire: Chevalier, Renaud Philippe
(86) Numéro de dépôt international: PCT/FR2013/052523
(87) Numéro de publication internationale: WO 2014/064382

(56) Documents cités:
- GB-A- 2 446 838
- US-A- 4 795 500
- US-A- 5 334 259
- US-A1- 2006 112 987
- US-A1- 2012 204 933
- TAKEOKA A ET AL: "DEVELOPMENT AND APPLICATION OF SEE-THROUGH A-SI SOLAR CELLS", SOLAR ENERGY MATERIALS AND SOLAR CELLS, ELSEVIER SCIENCE PUBLISHERS, AMSTERDAM, NL, vol. 29, no. 3, 1 avril 1993 (1993-04-01), pages 243-252, XP000355684, ISSN: 0927-0248, DOI: 10.1016/0927-0248(93)90039-6

## Description

La présente invention se rapporte à un procédé de fabrication d'un dispositif photovoltaïque à couches minces.

Elle se rapporte plus particulièrement à un procédé de fabrication d'un dispositif photovoltaïque comprenant les étapes suivantes :
- on fournit un substrat ;
- on pose un film photovoltaïque sur le substrat par la superposition de couches comprenant au moins une première couche conductrice formant un contact électrique arrière, une deuxième couche photo-active absorbant dans le spectre solaire à base de matériau inorganique, et une troisième couche en matériau conducteur transparent formant un contact électrique avant ;
- on divise le film photovoltaïque en une pluralité de cellules photovoltaïques individuelles et interconnectées, chaque cellule étant connectée en série ou en parallèle avec une ou plusieurs cellules adjacentes et isolée électriquement des autres cellules adjacentes.

Le dispositif photovoltaïque obtenu avec un tel procédé trouve une application particulière dans le domaine des vitrages dits solaires ou les vitrages dits photovoltaïques, dans lesquels le substrat est constitué d'un substrat en verre transparent - ou vitrage transparent - avec des cellules photovoltaïques interconnectées et plus ou moins espacées pour choisir le meilleur rapport entre la luminosité ou la transparence globale et la performance énergétique. Le vitrage peut être du type double vitrage ou triple vitrage, sous la forme d'un vitrage feuilleté, isolant, etc.

Cependant, la présente invention ne se limite pas à une telle application et d'autres substrats peuvent être envisagés avec un tel procédé, comme par exemple en employant un substrat en matériau organique, un substrat en matériau plastique ou à base de polymères, un substrat en verre traité, par exemple en verre dépoli, teinté, opaque, etc., un substrat métallique, un substrat en matériau de construction, par exemple en béton, en matériau composite, etc., éventuellement recouvert d'une couche de peinture et/ou de protection.

L'objet de la présente invention est d'appliquer sur le substrat une série de couches minces formant un film photovoltaïque définissant plusieurs cellules photovoltaïques interconnectées et conformées pour laisser passer une partie de la lumière afin de conférer au film photovoltaïque une certaine transparence qui assure la visibilité d'une partie du substrat. Ainsi, lefilm photovoltaïque offre des zones opaques et des zones transparentes qui permettent respectivement de dissimuler et d'exposer le substrat de l'extérieur. Pour la suite de la description, une zone du film photovoltaïque est considérée comme transparente dans la mesure où elle se laisse aisément traverser par la lumière et elle permet de distinguer nettement le substrat à travers son épaisseur.

L'intégration de dispositifs photovoltaïques dans un bâtiment est confrontée à plusieurs contraintes : la surface photovoltaïque utilisable sur toiture et/ou sur façade, le coût, les dimensions des dispositifs photovoltaïques qui doivent de préférence être standardisées pour respecter les normes et usages dans le domaine de la construction, l'installation des dispositifs photovoltaïques avec des contraintes d'isolation, d'étanchéité, de tenue mécanique, de prise au vent, etc. et l'esthétisme des dispositifs photovoltaïques en particulier dans une intégration sur façade.

Pour répondre à ces contraintes, il est connu d'employer des dispositifs photovoltaïques dits à couches minces ou « thin films », employant une couche photo-active absorbant dans le spectre solaire, d'une épaisseur variant de quelques atomes d'épaisseur à une dizaine de micromètres, réalisée à base de matériau inorganique semi-conducteur, notamment à base de Cu₂S/CdS, de a-Si:H (Silicium amorphe hydrogéné), CdTe (Tellure de cadmium), et CuInSe₂ (Cuivre Indium Sélénium ou CIS), de CuInGaSe₂ (Cuivre Indium Galium Sélénium ou CIGS).

Ces dispositifs photovoltaïques à couches minces à base de matériaux inorganiques appartiennent à la seconde génération, après la première génération à base de silicium cristallin, et avant la troisième génération à base de matériaux organiques.

Les matériaux photovoltaïques organiques sont naturellement transparents, cependant ils présentent des durées de vie limitées, généralement de l'ordre de quelques milliers d'heure, et des performances ou rendements électriques faibles (rendement de l'ordre de 5 à 9 % contre 15 à 20 % pour les matériaux photovoltaïques inorganiques de seconde génération), qui sont incompatibles avec une intégration dans un bâtiment.

Les matériaux photovoltaïques inorganiques ne possèdent pas de propriétés intrinsèques de transparence, et seul le dessin des cellules photovoltaïques sur le substrat conférera au film photovoltaïque une transparence nécessaire pour pouvoir voir en partie le substrat à travers le film. En effet, ces matériaux photovoltaïques inorganiques présentent un très fort niveau d'absorption de la lumière, avec par exemple une absorption de 99% de la lumière arrivant à la surface du matériau CIGS sur le premier micromètre d'épaisseur. Ainsi, pour le CIGS, une épaisseur de matériau supérieure à un micron conduit à une couche opaque à la lumière.

La présente invention s'intéresse donc à la réalisation du dessin des cellules photovoltaïques réalisées à base de couches minces de matériau photovoltaïque inorganique.

De manière générale, dans un dispositif photovoltaïque à couches minces, le film photovoltaïque est composé d'une superposition de couches comprenant une première couche conductrice formant un contact électrique arrière, une deuxième couche photo-active absorbant dans le spectre solaire et à base de matériau inorganique, une troisième couche en matériau conducteur transparent formant un contact électrique avant.

La troisième couche de contact avant peut être par exemple constituée d'une double pellicule d'oxyde de zinc (ZnO) dopée avec des éléments du groupe III comme l'aluminium, et elle présente une transmission lumineuse la plus grande possible dans la plage de longueur d'ondes liée à la deuxième couche photo-active. Il est connu d'employer une couche mince intermédiaire, appelée fenêtre ou couche « buffer », entre la deuxième et la troisième couches, généralement à base de CdS (sulfure de cadmium), de ZnS, ZnSe, SnIn₂Se₄, Zn₁₋ₓMgₓO, In₂S₃, etc.

La deuxième couche, appelée absorbeur, est réalisée à base de matériaux inorganiques semi-conducteur de type I-III-VI, comme par exemple le CIGS, souvent référencés comme des matériaux chalcogénures.

La première couche est déposée sur le substrat et possède à la fois des propriétés ohmiques pour assurer une récupération optimale des charges émises par la deuxième couche photo-active mais également des propriétés optiques pour assurer la réflexion vers la deuxième couche de la partie du spectre lumineux non absorbée en transmission directe.

Dans le domaine des vitrages solaires à base de couches minces de matériau photovoltaïque inorganique, il est connu de réaliser le vitrage solaire en déposant de manière uniforme un film photovoltaïque sur le substrat en verre, par superposition des couches minces précitées, puis en retirant par gravure mécanique ou laser des bandes dans le film photovoltaïque, ce qui permet d'obtenir des bandes photovoltaïques opaques et parallèles, présentant une largeur de l'ordre du centimètre et espacées régulièrement les unes des autres d'un écartement équivalent à la largeur des bandes ;les cellules étant interconnectées à leurs extrémités, les interconnexions étant généralement dissimulées par le cadre du vitrage.

Ainsi, la transparence globale du vitrage est de l'ordre de 50 %, mais ces bandes photovoltaïques réparties en réseau linéaire avec une résolution de l'ordre du centimètre offrent un réel inconfort visuel pour les utilisateurs du bâtiment qui regardent à travers le vitrage.

La présente invention a pour but de proposer un procédé de fabrication d'un dispositif photovoltaïque à couches minces réalisé avec un film photovoltaïque à base de matériau inorganique semi-conducteur, de seconde génération, qui permette de contrôler la géométrie des cellules photovoltaïques avec une résolution inférieure au millimètre, et de préférence de l'ordre du micromètre voire moins ou de la dizaine de micromètres, afin d'obtenir un film avec une transparence contrôlée entre 10 et 90 % et un confort visuel résultant d'une grande résolution qui apporte la perception d'une quasi uniformité du dessin des couches opaques.

À cet effet, elle propose un procédé de fabrication d'un dispositif photovoltaïque à couches minces, comprenant les étapes suivantes :
- on fournit un substrat ;
- on pose un film photovoltaïque sur ledit substrat par la superposition de couches comprenant au moins une première couche conductrice formant un contact électrique arrière, une deuxième couche photo-active absorbant dans le spectre solaire à base de matériau inorganique, et une troisième couche en matériau conducteur transparent formant un contact électrique avant ;
- on divise le film photovoltaïque en une pluralité de cellules photovoltaïques individuelles et interconnectées, chaque cellule étant connectée en série ou en parallèle avec une ou plusieurs cellules adjacentes et isolée électriquement des autres cellules adjacentes,
où le procédé est remarquable en ce qu'on ménage, au moment de la pose du film photovoltaïque, une pluralité de trous individuels traversant au moins les première et deuxième couches du film photovoltaïque dans chaque cellule, par application d'un masque selon un procédé d'impression, notamment du type impression numérique par jet de matière, flexographie, sérigraphie, ou tampographie, ledit masque présentant des zones principales définissant un pochoir en positif desdits trous.

L'emploi d'un tel masque déposé par impression est vraiment avantageux pour obtenir les résolutions souhaitées dans la répartition des trous. Grâce à cette technique d'impression (sur le substrat, sur une couche de résine ou sur la première couche, comme expliqué ultérieurement), il est possible de garantir des dimensions micrométriques des trous et des écartements micrométriques entre les trous.

Conformément à l'invention, le masque sert donc à réaliser des trous au moins dans la première couche et dans la deuxième couche, pour obtenir une transparence contrôlée du film photovoltaïque.

Selon une possibilité de l'invention, on effectue la séquence dite principale comportant les étapes suivantes :
- on ménage les trous dans la première couche au moyen du masque ;
- on dépose la deuxième couche sur les parties non trouées de la première couche conductrice, de préférence par électrodéposition ;
- on dépose la troisième couche, de préférence par évaporation.

La troisième couche transparente ne modifie pas la transparence et peut donc venir recouvrir les zones à nu du substrat dans les orifices traversant la première couche.

Il est envisageable de prévoir plusieurs modes d'utilisation du masque.

Selon une première utilisation du masque, ne faisant pas partie de l'invention, on réalise la première séquence suivante :
- on dépose une première couche conductrice uniforme sur le substrat ;
- on dépose une couche de résine photosensible sur la première couche conductrice uniforme ;
- on dépose le masque sur la couche de résine, ledit masque formant un pochoir en positif de la conformation géométrique des trous ;
- on insole la résine par application d'un rayonnement lumineux ;
- on élimine les zones de la couche de résine non exposées au rayonnement lumineux et correspondant aux zones de la couche de résine masquées par le masque, mettant à nu des zones de la première couche conductrice uniforme et laissant en place des ilots de résine insolée ;
- on élimine les zones mises à nu de la première couche conductrice, entre les ilots de résine insolée, formant ainsi des orifices traversant dans ladite première couche conductrice ;
- on élimine les ilots de résine insolée restants sur la première couche conductrice, laissant sur le substrat uniquement la première couche conductrice présentant des orifices en positif du masque.

Ensuite, on reprend les étapes de la séquence principale évoquée ci-dessus.

Selon une deuxième utilisation du masque, ne faisant pas partie de l'invention, on réalise la deuxième séquence suivante :
- on dépose une couche de résine photosensible sur le substrat ;
- on dépose le masque sur la couche de résine, ledit masque formant un pochoir en négatif de la conformation géométrique des trous ;
- on insole la résine par application d'un rayonnement lumineux ;
- on élimine les zones de la couche de résine non exposées au rayonnement lumineux et correspondant aux zones de la couche de résine masquées par le masque, mettant à nu des zones du substrat et laissant en place des ilots de résine insolée ;
- on dépose de manière uniforme une première couche conductrice qui recouvre les ilots de résine insolée restants et les zones mises à nu du substrat.

A la suite de cette deuxième séquence, deux options sont envisageables.

Dans une première option, à la suite du dépôt de la première couche conductrice, on élimine les ilots de résine insolée restants, laissant sur le substrat uniquement la première couche conductrice présentant des orifices en négatif du masque. Ensuite, on reprend les étapes de la séquence principale évoquée ci-dessus.

Dans une seconde option, à la suite du dépôt de la première couche conductrice :
- on dépose de manière uniforme la deuxième couche qui recouvre la première couche conductrice ;
- on dépose de manière uniforme la troisième couche qui recouvre la deuxième couche ;
- on élimine les ilots de résine insolée restants, laissant sur le substrat le film photovoltaïque présentant des trous en négatif du masque.

Dans cette deuxième option, les deuxième et troisième couches sont uniformément déposées, de préférence par vaporisation, et non de manière sélective comme dans le cas de la première option.

Selon une troisième utilisation du masque, on réalise la séquence suivante :
- on dépose le masque sur le substrat, ledit masque formant un pochoir en positif de la conformation géométrique des trous ;
- on dépose de manière uniforme une première couche conductrice qui recouvre le masque et les zones nues du substrat.

Ainsi, on dépose le masque directement sur le substrat, et non plus sur une couche de résine comme dans les première et deuxième utilisations. A la suite de cette séquence, deux options sont envisageables.

Dans une première option, à la suite du dépôt de la première couche conductrice, on élimine le masque, laissant sur le substrat uniquement la première couche conductrice présentant des orifices en positif du masque. Ensuite, on reprend les étapes de la séquence principale évoquée ci-dessus, en l'occurrence :
- on dépose la deuxième couche sur les parties non trouées de la première couche conductrice, de préférence par électrodéposition ;
- on dépose la troisième couche, de préférence par évaporation.

Dans une seconde option, à la suite du dépôt de la première couche conductrice :
- on dépose de manière uniforme la deuxième couche qui recouvre la première couche conductrice ;
- on dépose de manière uniforme la troisième couche qui recouvre la deuxième couche ;
- on élimine le masque, laissant sur le substrat le film photovoltaïque présentant des trous en positif du masque.

De manière avantageuse, le masque présente des zones secondaires définissant un positif ou un négatif de bandes de séparation entre les cellules.

Ainsi, on profite du masque pour préparer directement la séparation entre les cellules photovoltaïques.

De manière avantageuse, les trous sont ménagés en respectant les caractéristiques géométriques suivantes :
- chaque trou présente des dimensions dans le plan principal comprises entre 10 nanomètres et 400 micromètres,
- chaque trou est distant du trou adjacent le plus proche d'une distance comprise entre 5 nanomètres et 400 micromètres,
- chaque cellule présente une surface trouée, correspondant à la surface des trous disposés dans ladite cellule dans le plan principal, qui est comprise entre 10 et 90% de la surface totale de la cellule (30) dans ce même plan principal, de préférence entre 30 et 70%.

Ainsi, les cellules photovoltaïques sont trouées, au moins sur l'épaisseur des première et deuxième couches (la troisième couche étant transparente), et ces trous sont répartis de manière quasi uniforme dans chaque cellule avec une résolution comprise entre 5 nanomètres et 400 micromètres, garantissant une perception pour l'oeil humain quasi uniforme de la surface externe du film, avec une transparence maîtrisée du film qui assure une visibilité du support à travers le film.

En effet, le pouvoir de résolution de l'oeil (distance minimale qui doit exister entre deux points contigus pour qu'ils soient correctement discernés) est d'environ une minute d'arc, soit 0,017°, ce qui correspond à une distance minimale d'environ 600 micromètres pour une image située à 2 mètres de distance de l'oeil.

Selon une première possibilité, on répartit les trous sur la surface de chaque cellule selon une distribution non périodique, notamment selon un pavage non périodique. Par exemple, on répartit les trous sur la surface de chaque cellule selon une distribution aléatoire, notamment selon un pavage aléatoire.

Selon une seconde possibilité, on répartit les trous sur la surface de chaque cellule selon une distribution périodique, notamment selon un pavage périodique.

Selon une caractéristique, les trous sont répartis sur la surface de chaque cellule selon un pavage virtuel composé d'une pluralité d'unités élémentaires photovoltaïques juxtaposées sans vide et sans empiétement pour définir la cellule correspondante, chaque unité élémentaire se présentant sous la forme d'une portion géométrique du film photovoltaïque délimitée par un contour virtuel et à laquelle est associé au moins un trou ménagé en tout ou partie à l'intérieur dudit contour, chaque trou étant associé à une unique unité élémentaire, et dans lequel chaque unité élémentaire présente une surface trouée, correspondant à la surface du ou des trous associés à ladite unité élémentaire dans le plan principal, qui est comprise entre 10 et 90% de la surface totale de l'unité élémentaire dans ce même plan principal, de préférence entre 30 et 70%.

Ainsi, chaque cellule photovoltaïque est géométriquement définie par un pavage d'unités élémentaires photovoltaïques et chacune de ces unités présentes est trouée pour offrir intrinsèquement la transparence globale voulue. De cette manière, la cellule photovoltaïque macroscopique présente la même transparence que ces propres unités élémentaires qui la composent.

Selon une autre caractéristique, chaque unité élémentaire présente des dimensions dans le plan principal comprises entre 10 et 800 micromètres.

Dans un mode de réalisation particulier, le substrat est constitué d'un substrat en verre, pour réaliser un vitrage photovoltaïque ou solaire.

De préférence, la première couche est une couche métallique opaque. Cette première couche est positionnée côté substrat, notamment directement en contact sur le substrat.

D'autres caractéristiques et avantages de la présente invention apparaîtront à la lecture de la description détaillée ci-après, de plusieurs exemples de mise en oeuvre non limitatifs, faite en référence aux figures annexées dans lesquelles :

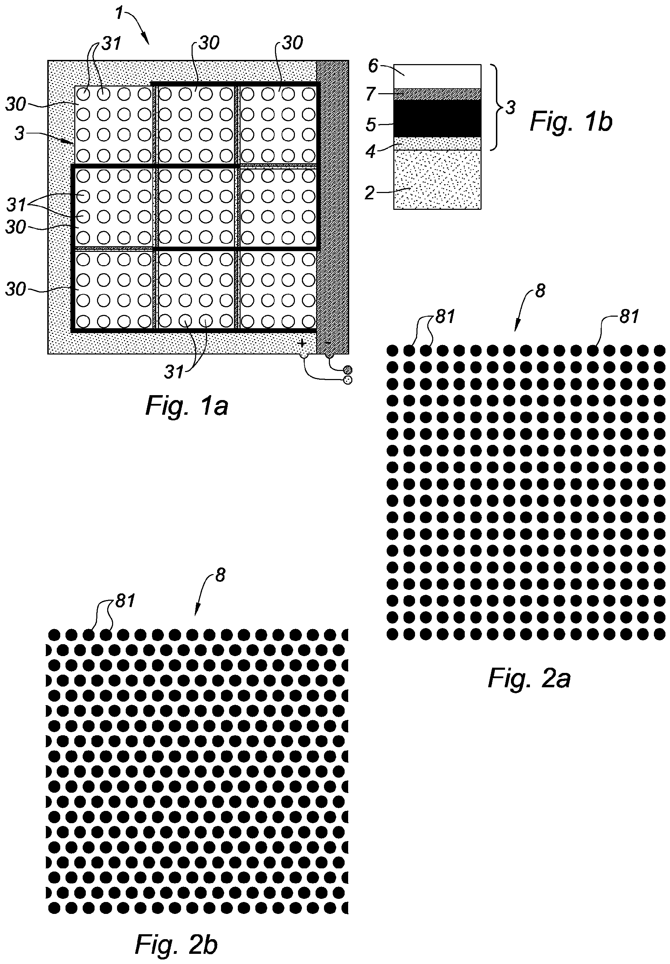

- la figure 1 a est une vue schématique de face d'un dispositif photovoltaïque conforme à l'invention ;
- la figure 1 b est une vue schématique en coupe du film photovoltaïque du dispositif de la figure 1 a ;
- la figure 2a est une vue schématique de face d'un masque établi selon un premier pavage périodique orthogonal ou carré ;
- la figure 2b est une vue schématique de face d'un masque établi selon un second pavage périodique en quinconce ou en nid d'abeille ;
- la figure 3a est une vue schématique de face d'un masque établi selon un premier pavage non périodique du type « pinwheel » ;

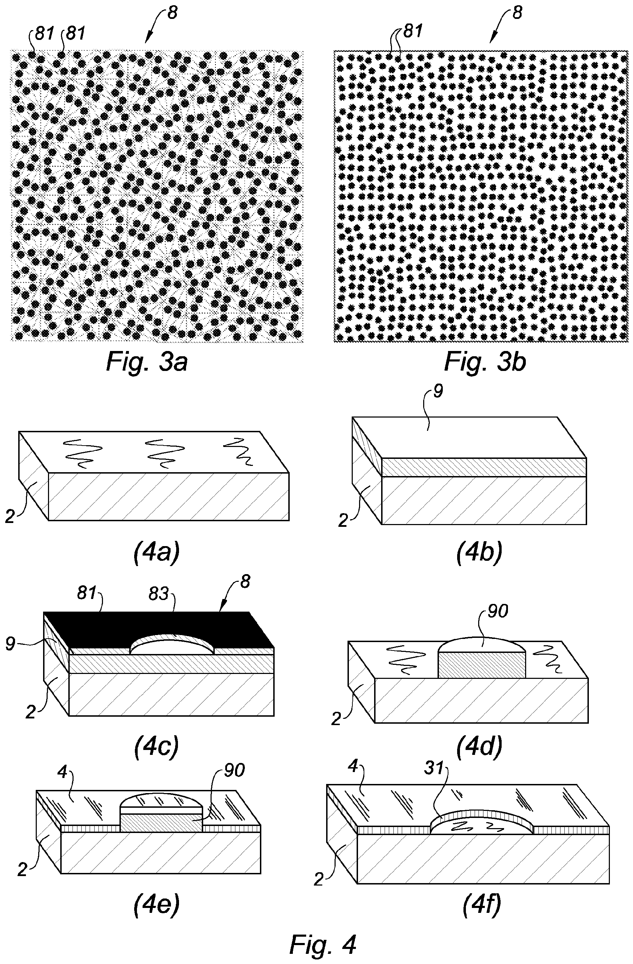

- la figure 3a est une vue schématique de face d'un masque établi selon un second pavage non périodique du type aléatoire ;
- la figure 4 représente des vues schématiques en coupe partielle d'une première séquence de réalisation, ne faisant pas partie de l'invention, sur un substrat d'une première couche conductrice avec des orifices traversant (six étapes 4a à 4f étant illustrées) ;

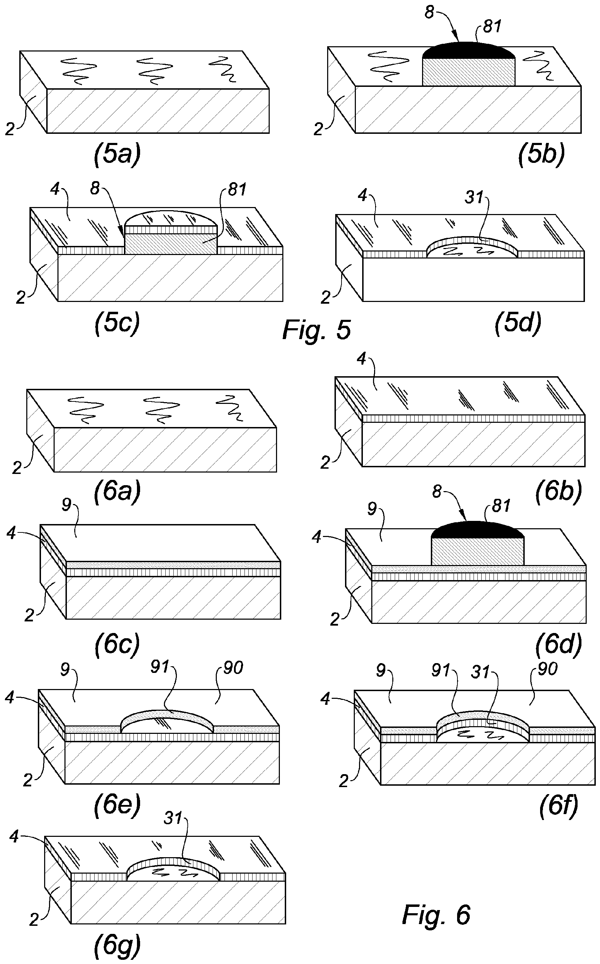

- la figure 5 représente des vues schématiques en coupe partielle d'une deuxième séquence de réalisation sur un substrat d'une première couche conductrice avec des orifices traversant (quatre étapes 5a à 5d étant illustrées) ;
- la figure 6 représente des vues schématiques en coupe partielle d'une troisième séquence de réalisation, ne faisant pas partie de l'invention, sur un substrat d'une première couche conductrice avec des orifices traversant (sept étapes 6a à 6g étant illustrées) ;

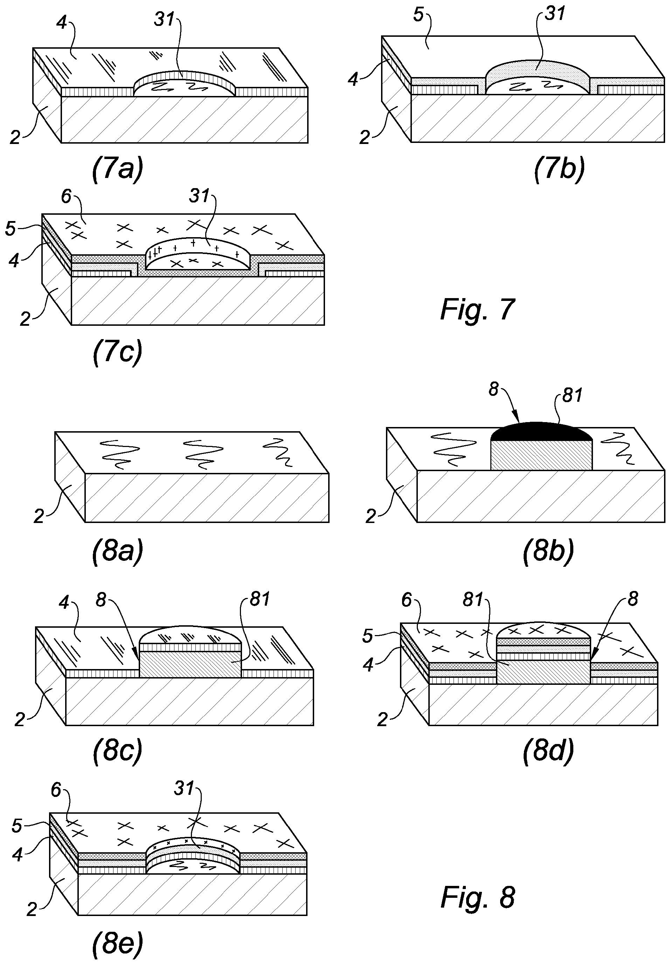

- la figure 7 représente des vues schématiques en coupe partielle d'une séquence supplémentaire de dépôt des deuxième et troisième couches, à la suite de la première, deuxième ou troisième séquences illustrées sur les figures 4 à 6 (deux étapes 7a et 7b étant illustrées) ;
- la figure 8 représente des vues schématiques en coupe partielle d'une séquence de dépôt sur un substrat des première, deuxième et troisième couches avec des trous traversant (cinq étapes 8a à 8e étant illustrées) ;

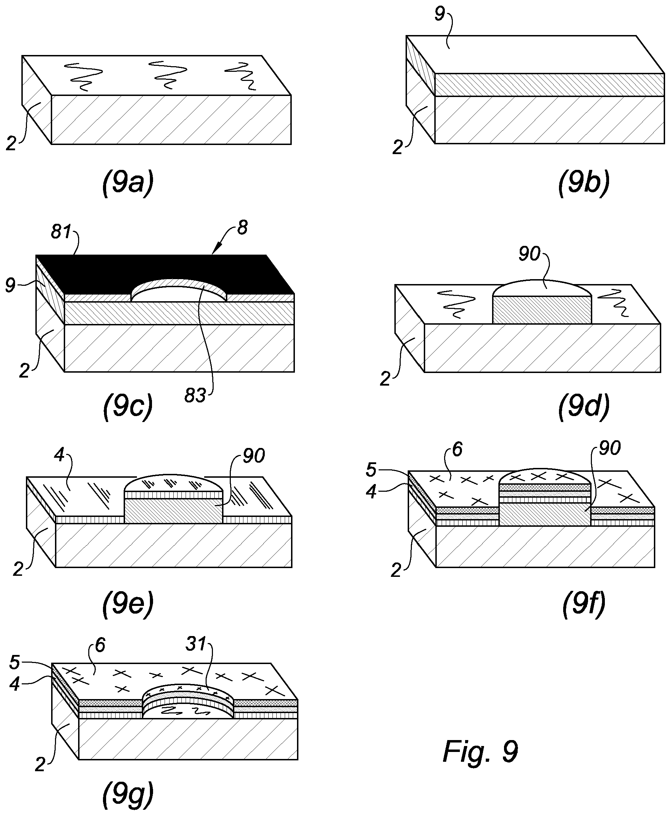

- la figure 9 représente des vues schématiques en coupe partielle d'une autre séquence de dépôt, ne faisant pas partie de l'invention, sur un substrat des première, deuxième et troisième couches avec des trous traversant (sept étapes 9a à 9g étant illustrées) ;

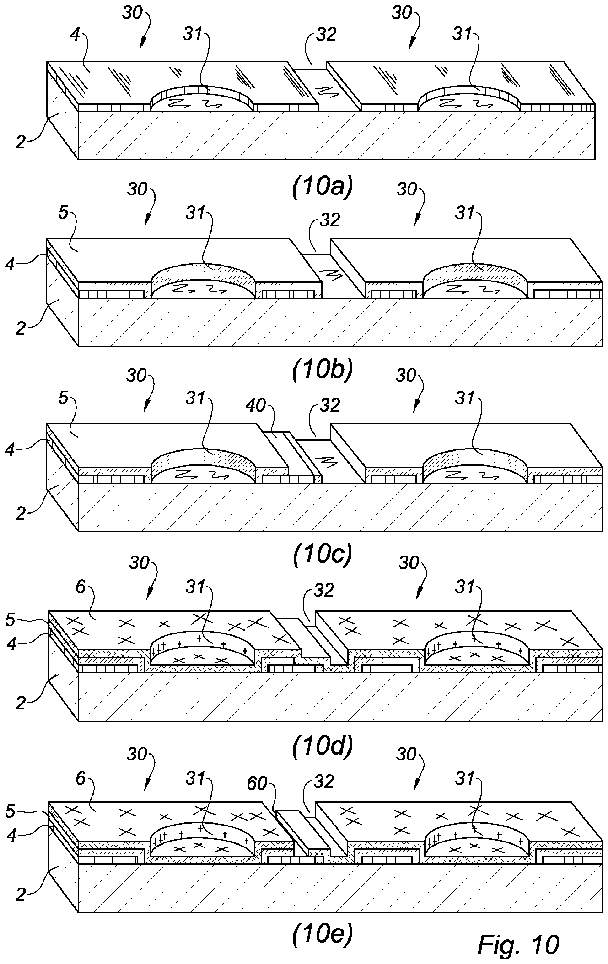

- la figure 10 représente des vues schématiques en coupe partielle d'une séquence supplémentaire de dépôt des deuxième et troisième couches, à la suite de la première, deuxième ou troisième séquences illustrées sur les figures 4 à 6 (cinq étapes 10a à 10e étant illustrées), où la figure 10 illustre plus spécifiquement la mise en oeuvre d'étapes d'interconnexion entre deux cellules adjacentes ;

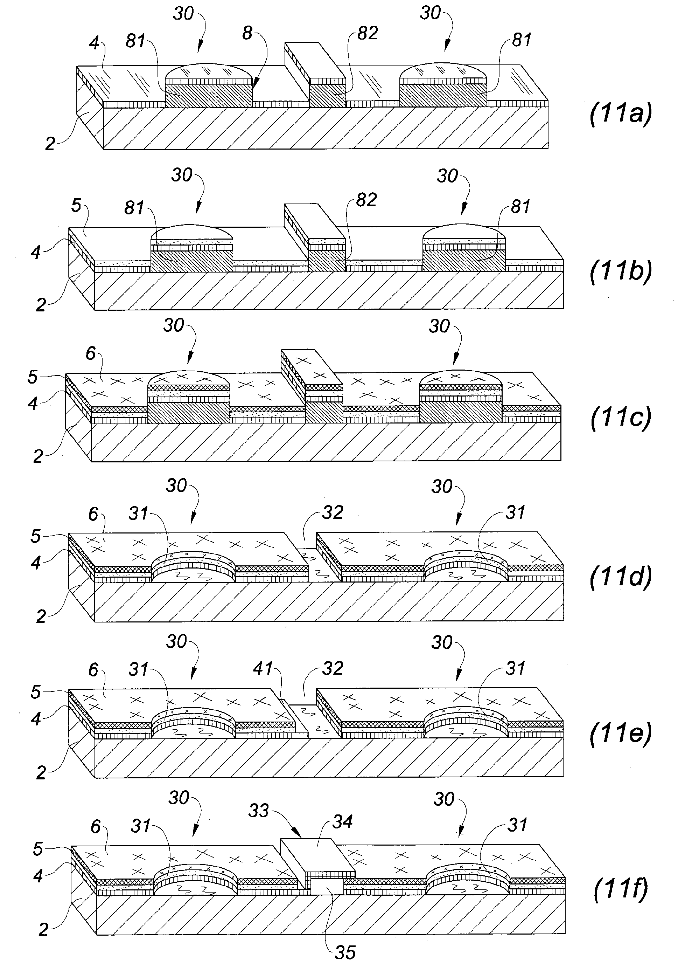

- la figure 11 représente des vues schématiques en coupe partielle d'une séquence de dépôt sur un substrat des première, deuxième et troisième couches avec des trous traversant (six étapes 11a à 11f étant illustrées), où la figure 11 illustre plus spécifiquement la mise en oeuvre d'étapes d'interconnexion entre deux cellules adjacentes ;

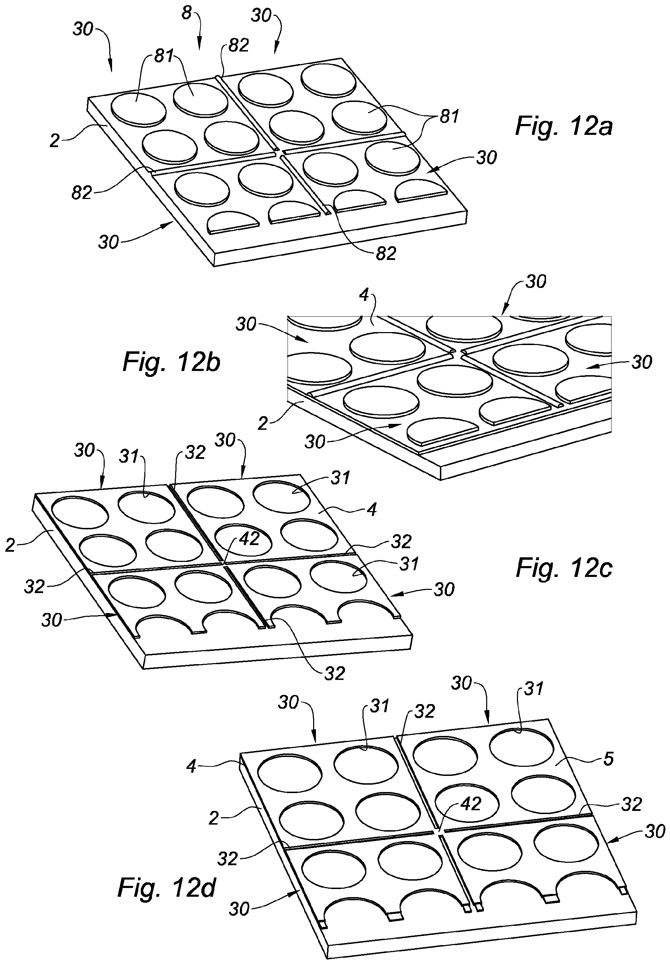

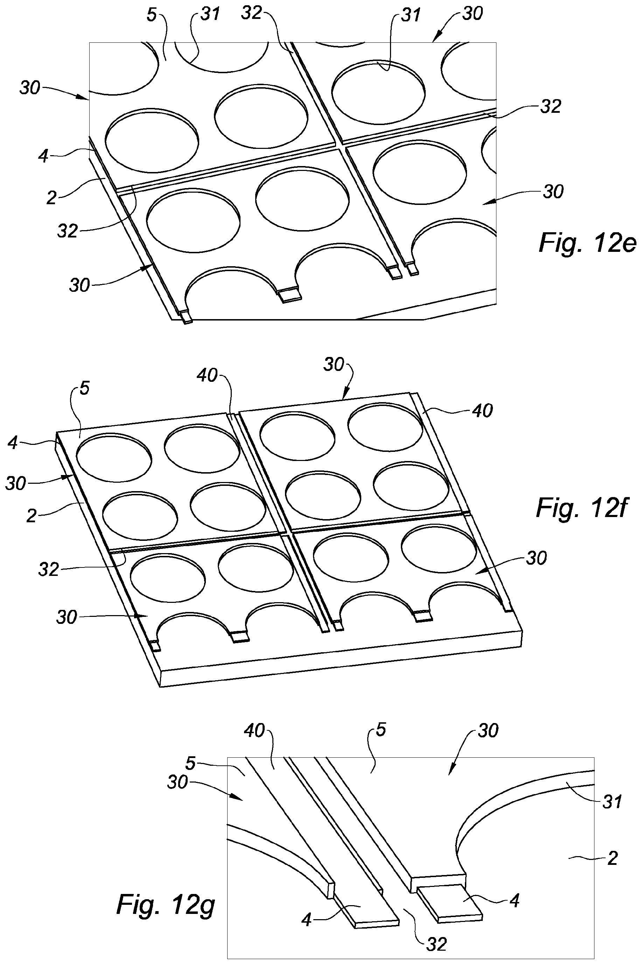

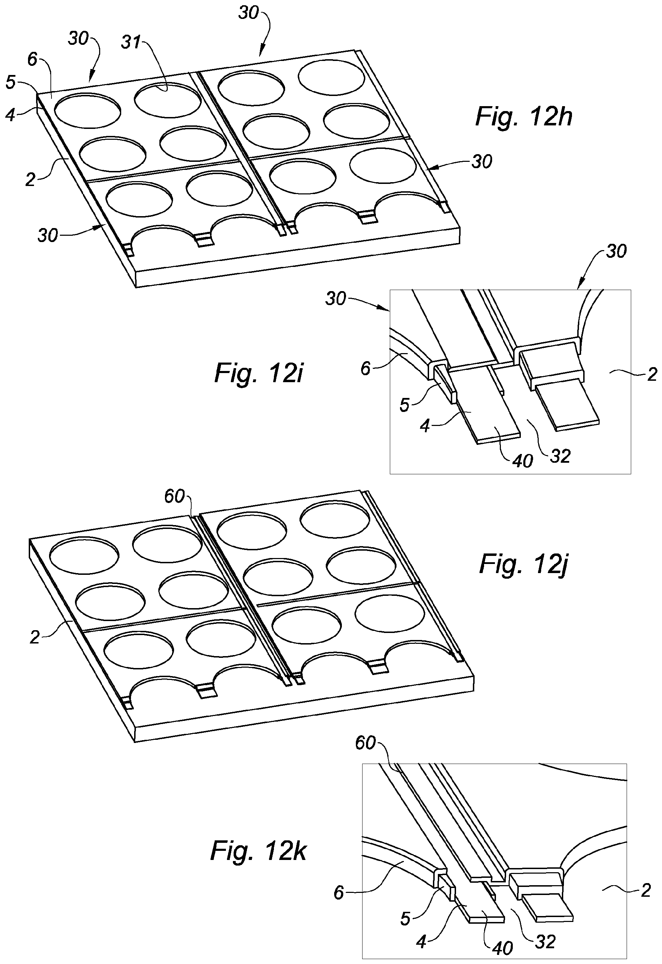

- les figures 12a à 12k représente des vues schématiques en perspective d'une séquence de dépôt sur un substrat des première, deuxième et troisième couches avec des trous traversant (huit étapes étant illustrées, la figure 12g étant un zoom d'une partie de la figure 12f et la figure 12k étant un zoom d'une partie de la figure 12j), où la séquence est identique à celle de la figure 10, les figures 12a à 12k illustrant quatre cellules adjacentes deux à deux ;

En référence aux figures 1 a et 1 b, un dispositif photovoltaïque 1 à couches minces conforme à l'invention comprend :
- un substrat 2, tel qu'un substrat en verre pour une application dans les vitrages solaires ; et
- un film photovoltaïque 3 composé d'une superposition de couches réparties selon un plan dit principal, et divisé en une pluralité de cellules 30 photovoltaïques individuelles et interconnectées entre elles, chaque cellule 30 étant connectée en série ou en parallèle avec une ou plusieurs cellules 30 adjacentes et isolée des autres cellules adjacentes.

En référence à la figure 1 b, le film photovoltaïque 3 est composé d'une superposition des couches minces successives suivantes :
- une première couche 4 conductrice, notamment du type métallique, formant un contact électrique arrière déposé sur le substrat ;
- une deuxième couche 5 photo-active absorbant dans le spectre solaire à base de matériau inorganique, notamment à base de CIGS ;
- une troisième couche 6 en matériau conducteur transparent formant un contact électrique avant, notamment en oxyde conducteur ; et
- éventuellement une couche mince intermédiaire 7, appelée fenêtre ou couche « buffer » et notamment à base de CdS, entre la deuxième et la troisième couches 5, 6.

Chaque cellule 30 comprend une pluralité de trous 31 individuels traversant soit les première et deuxième couches 4, 5, soit les première, deuxième et troisième couche 4, 5, 6 ; ces trous 30 assurant ainsi une semi-transparence des cellules 30, les zones trouées étant transparentes à la lumière visible et les zones non trouées étant opaques à la lumière visible.

Ces trous 31 sont avantageusement répartis sur chaque cellule 30 selon la conformation géométrique suivante :
- chaque trou 31 présente des dimensions dans le plan principal comprises entre 10 nanomètres et 400 micromètres (ces dimensions correspondant à leurs diamètres dans le cas de trous circulaires) ;
- chaque trou 31 est distant du trou 31 adjacent le plus proche d'une distance comprise entre 5 nanomètres et 400 micromètres ;
- la surface totale des trous 31 disposés dans la cellule 30 prise dans le plan principal est comprise entre 10 et 90% de la surface totale de la cellule 30 dans ce même plan principal.

Ainsi, chaque cellule 30 présente une transparence comprise entre 10 et 90 %, suivant la surface totale occupée par les trous 31 dans la cellule 30 concernée. Les dimensions des trous 31 et les distances inter-trous sont choisies pour offrir un confort visuel en accord avec le pouvoir de résolution de l'oeil, de sorte que l'oeil humain distingue peu les trous 31 dans les cellules 30 et voit une surface sensiblement uniforme.

La suite de la description porte sur le procédé de fabrication d'un tel dispositif photovoltaïque 1, en partant du substrat 2 sur lequel on souhaite déposer le film photovoltaïque 3 divisé en cellules 30 trouées et interconnectées ; plusieurs variantes étant envisageables.

Les figures 4 à 6 illustrent trois séquences distinctes permettant de réaliser une première couche 4 trouée selon la conformation géométrique précitée, en utilisant un masque 8 selon un procédé d'impression, notamment du type impression numérique par jet de matière, flexographie, sérigraphie, ou tampographie, ledit masque 8 présentant des zones dites principales 81 définissant un positif ou un négatif des trous 31.

Ce masque 8 servira de pochoir qui va permettre de réaliser la répartition des trous 31 sur la première couche 4 selon la conformation géométrique précitée, les zones principales 81 du masque 8 définissant :
- soit un positif des trous 31, autrement dit les zones occultées par les zones principales 81 correspondront in fine aux trous 31 ;
- soit un négatif des trous 31, autrement dit les zones non occultées par les zones principales 81 correspondront in fine aux trous 31.

En travaillant par impression, le masque 8 prendre la forme d'une couche de matière de masquage, tel que de l'encre, formant le négatif ou le positif des trous 31.

Dans le cas d'un masque 8 formant un positif des trous 31, le masque 8 comporte, pour chaque cellule, une pluralité de zones principales 81 de matière de masquage, individuelles et réparties sur chaque cellule selon la conformation géométrique suivante :
- chaque zone principale 81 présente des dimensions dans le plan principal comprises entre 10 nanomètres et 400 micromètres (ces dimensions correspondant à leurs diamètres dans le cas de zones 81 circulaires) ;
- chaque zone principale 81 est distante de la zone principale 81 adjacente la plus proche d'une distance comprise entre 5 nanomètres et 400 micromètres ;
- la surface totale des zones principales 81 disposées dans la cellule prise dans le plan principal est comprise entre 10 et 90% de la surface totale de la cellule 30 dans ce même plan principal.

Ainsi, avec un masque 8 formant un positif des trous 31, le masque 8 se présente, pour chaque cellule, sous la forme d'une pluralité de zones principales 81 écartées les unes des autres (comme notamment illustré sur la figure 12a et les figures 2a, 2b, 3a et 3b).

Dans le cas d'un masque 8 formant un négatif des trous 31, le masque 8 comporte, pour chaque cellule, des zones principales 81 contigües encadrant des trous 83 individuels répartis sur chaque cellule selon la conformation géométrique suivante :
- chaque trou 83 du masque 8 présente des dimensions dans le plan principal comprises entre 10 nanomètres et 400 micromètres (ces dimensions correspondant à leurs diamètres dans le cas de trous circulaires) ;
- chaque trou 83 du masque 8 est distant du trou 83 adjacent le plus proche d'une distance comprise entre 5 nanomètres et 400 micromètres ;
- la surface totale des trous 83 du masque 8 disposés dans la cellule prise dans le plan principal est comprise entre 10 et 90% de la surface totale de la cellule dans ce même plan principal.

Ainsi, avec un masque 8 formant un négatif des trous 31, le masque 8 se présente, pour chaque cellule, sous la forme d'une couche continue de matière de masquage, dans laquelle sont prévus des trous 83 écartés les uns des autres (comme visible sur la figure 4c).

Dans la première séquence, ne faisant pas partie de l'invention, illustrée sur la figure 4, on prévoit un substrat 2 (figure 4a), puis :
- on dépose une couche de résine 9 photosensible sur le substrat 2 (figure 4b) ;
- on dépose le masque 8, réalisé dans une couche de matière de masquage opaque, sur la couche de résine 9, ce masque 8 opaque formant un pochoir en négatif de la conformation géométrique des trous 31 en présentant des trous 83 comme décrit ci-dessus (figure 4c) ;
- on insole la résine 9 par application d'un rayonnement lumineux, puis on élimine chimiquement (par décapage) les zones de la couche de résine 9 non exposées au rayonnement lumineux et correspondant aux zones de la couche de résine 9 masquées par le masque 8, mettant à nu des zones du substrat et laissant en place des ilots de résine 90 insolée (figure 4d) ;

- on dépose de manière uniforme, par pulvérisation ou par évaporation, une première couche 4 qui recouvre les ilots de résine 90 insolée restants et les zones mises à nu du substrat 2 (figure 4e) ;
- on élimine les ilots de résine 90 insolée restants, laissant sur le substrat 2 uniquement la première couche 4 présentant des orifices 31 en négatif du masque 8.

Dans la deuxième séquence illustrée sur la figure 5, on prévoit un substrat 2 (figure 5a), puis :
- on dépose le masque 8 sur le substrat 2, ce masque 8 formant un pochoir en positif de la conformation géométrique des trous 31 en présentant des zones principales 81 individuelles comme décrit ci-dessus (figure 5b) ;
- on dépose de manière uniforme, par pulvérisation ou par évaporation, une première couche 4 qui recouvre le masque 8 et les zones nues (non masquées) du substrat 2 (figure 5c) ;
- on élimine chimiquement le masque 8, laissant sur le substrat 2 uniquement la première couche 4 présentant des orifices 31 en positif du masque 8 (figure 5d).

Dans cette deuxième séquence, les caractéristiques optiques du masque 8 sont sans importance, autrement dit le masque 8 peut être opaque ou non. En effet, le masque 8 est employé pour former une barrière physique pour le dépôt de la première couche 4, sans utilisation d'une étape d'insolation.

Dans la troisième séquence, ne faisant pas partie de l'invention, illustrée sur la figure 6, on prévoit un substrat 2 (figure 6a), puis :
- on dépose de manière uniforme, par pulvérisation ou par évaporation, une première couche 4 sur le substrat 2 (figure 6b) ;
- on dépose une couche de résine 9 photosensible sur la première couche 4 uniforme (figure 6c) ;
- on dépose le masque 8, réalisé dans une couche de matière de masquage opaque, sur la couche de résine 9, ce masque 8 opaque formant un pochoir en positif de la conformation géométrique des trous 31,en présentant des zones principales 81 individuelles comme décrit ci-dessus (figure 6d) ;
- on insole la résine 9 par application d'un rayonnement lumineux à travers le masque 8 précédemment déposé, et ensuite on élimine chimiquement (par décapage) les zones de la couche de résine 9 non exposées au rayonnement lumineux et correspondant aux zones de la couche de résine 9 masquées par les zones principales 81 du masque, mettant à nu des zones de la première couche 4 uniforme et laissant en place des ilots de résine 90 insolée entourant des trous 91 dans la couche de résine 9 (figure 6e) ;
- on élimine par gravure chimique les zones mises à nu de la première couche 4, entre les ilots de résine90 insolée et à travers les trous 91, formant ainsi des orifices traversant - soit les trous 31 - dans la première couche 4 (figure 6f) ;
- on élimine les ilots de résine 90 insolée restants sur la première couche 4, laissant sur le substrat 2 uniquement la première couche 4 présentant les trous 31 en positif du masque 8 (figure 6g).

En partant de la fin de l'une ou l'autre des trois séquences décrites ci-dessus en référence aux figures 4 à 6, on obtient donc sur le substrat 2 une première couche 4 avec des trous 31 disposés conformément à la conformation géométrique souhaitée.

Pour déposer les deuxième et troisième couches 5, 6 sur une telle première couche 4 trouée, il est envisageable de procéder comme suit, en référence à la figure 7 :
- on dispose du substrat 2 sur lequel est déposée la première couche 4 avec les trous 31 (figure 7a) ;
- on dépose par électrodéposition la deuxième couche 5 sur les parties non trouées de la première couche 4 (figure 7b),la première couche 4 conductrice servant d'électrode qui va attirer le matériau semi-conducteur photo-actif de la deuxième couche 5 une fois la première couche 4 polarisée et plongée dans un bain d'électrodéposition, les zones mises à nu du substrat 2 non polarisées étant épargnées par l'électrodéposition ;
- on dépose par évaporation la troisième couche 6 (figure 7c).

Le dépôt de la troisième couche 6 s'effectue par évaporation, recouvrant ainsi totalement la surface, y compris les trous 31, ce qui ne cause aucun préjudice car la troisième couche 6 est par nature transparente, et en outre l'étape d'électrodéposition garantit que la deuxième couche 5 enveloppe complètement la première couche 4, ce qui évite que la troisième couche 6 ne soit en contact avec la première couche 4 et ne court-circuite la cellule.

Dans le cas des trois séquences précitées employant un masque 8, on a utilisé le masque 8 uniquement pour réaliser les trous 31 dans la première couche 4, avant de s'en débarrasser pour procéder au dépôt de la deuxième couche 5 par électrodéposition.

Il est cependant envisageable de prévoir des variantes dans lequel le masque 8 est conservé et retiré uniquement en fin de processus, après déposition des deuxième et troisième couches 5.

Dans une première variante illustrée sur la figure 8, qui constitue une variante de la deuxième séquence de la figure 5, on prévoit un substrat 2 (figure 8a), puis :
- on dépose le masque 8 sur le substrat 2, ce masque 8 formant un pochoir en positif de la conformation géométrique des trous 31 en présentant des zones principales 81 comme décrit ci-dessus (figure 8b) ;
- on dépose de manière uniforme, par pulvérisation ou par évaporation, une première couche 4 qui recouvre le masque 8 et les zones nues (non masquées) du substrat 2 (figure 8c) ;
- on dépose de manière uniforme, par pulvérisation ou par évaporation, une deuxième couche 5, puis on dépose de manière uniforme, par pulvérisation ou par évaporation, une troisième couche 6 (figure 8d) ; et
- on élimine chimiquement le masque 8, laissant sur le substrat 2 uniquement les première, deuxième et troisième couches 4, 5, 6 présentant les trous 31 en positif du masque 8 (figure 8e).

Dans une seconde variante, ne faisant pas partie de l'invention, illustrée sur la figure 9, qui constitue une variante de la première séquence de la figure 4, on prévoit un substrat 2 (figure 9a), puis :
- on dépose une couche de résine 9 photosensible sur le substrat 2 (figure 9b) ;
- on dépose le masque 8, réalisé dans une couche de matière de masquage opaque, sur la couche de résine 9, ce masque formant un pochoir en négatif de la conformation géométrique des trous (figure 9c) ;
- on insole la résine 9 par application d'un rayonnement lumineux, puis on élimine chimiquement (par décapage) les zones de la couche de résine 9 non exposées au rayonnement lumineux et correspondant aux zones de la couche de résine 9 masquées par le masque 8 opaque, mettant à nu des zones du substrat et laissant en place des ilots de résine 90 insolée (figure 9d) ;
- on dépose de manière uniforme, par pulvérisation ou par évaporation, une première couche 4 qui recouvre les ilots de résine 90 insolée restants et les zones mises à nu du substrat 2 (figure 9e) ;
- on dépose de manière uniforme, par pulvérisation ou par évaporation, une deuxième couche 5, puis on dépose de manière uniforme, par pulvérisation ou par évaporation, une troisième couche 6 (figure 9f) ; et
- on élimine les ilots de résine 90 insolée restants, laissant sur le substrat 2 uniquement les première, deuxième et troisième couches 4, 5, 6 présentant les trous 31 en négatif du masque 8 (figure 9g).

Dans ces deux variantes, la troisième couche 6 ne recouvre pas les trous 31, car le masque 8 est retiré après la pose de cette troisième couche 6, évitant ainsi un court-circuit entre les première et troisième couches 4, 6.

La suite de la description porte sur la division du film photovoltaïque en plusieurs cellules, et sur l'interconnexion entre deux cellules adjacentes, faite en référence aux figures 10 à 12.

Les figures 10 et 12 illustrent un perfectionnement des étapes de la figure 7, en portant sur des sous-étapes destinées à assurer l'interconnexion entre deux cellules 30 adjacentes, autrement dit la connexion électrique entre la première couche 4 d'une cellule 30 et la troisième couche 6 d'une cellule 30 adjacente.

Les figures 10a et 12c illustrent chacune un substrat 2 sur lequel est déposée une première couche 4 avec deux cellules 30 (figure 10a) ou quatre cellules 30 (figure 12c) séparées par des bandes de séparation 32 respectives. Chaque bande de séparation 32 sépare électriquement la première couche 4 d'une cellule 30 de la première couche 4 d'une cellule 30 adjacente.

Plusieurs modes de réalisation des bandes de séparation 32 peuvent être envisagés, étant précisé qu'une bande de séparation 32 constitue une rainure ou encoche trouée dans la première couche 4. Ainsi, on réalise la bande de séparation 32 de la même manière que l'on réalise les trous 31.

Dans une première réalisation, la bande de séparation 32 est réalisée par gravure directe, de la même manière que dans la première séquence illustrée sur la figure 3.

Dans une deuxième réalisation, la bande de séparation 32 est réalisée à partir d'un masque qui présente des zones secondaires 82 définissant un positif ou un négatif des bande de séparation 32 entre les cellules, c'est-à-dire :
- soit un positif comme dans les deuxième et troisième séquences des figures 5 et 6, les zones secondaires 82 se présentant alors sous la forme de bandes 82 qui délimitent les cellules 30 ;
- soit un négatif comme dans la première séquence de la figure 4, les zones secondaires 82 encadrant des fentes qui délimitent les cellules 30 et qui traversent la couche du masque 8.

La figure 12a illustre l'application d'un masque 8 en positif directement sur le substrat (comme dans la deuxième séquence illustrée sur la figure 5) avec les zones principales 81 et secondaires 82. On note que les zones secondaires 82 ne sont pas jointives à l'intersection des quatre cellules 30.

La figure 12b illustre ensuite l'application uniforme de la première couche 4 sur le substrat 2 et le masque 8.

La figure 12c illustre l'étape d'élimination chimique du masque 8, laissant sur le substrat 2 uniquement la première couche 4 présentant les trous 31 et les bandes de séparation 32. On note que les premières couches 4 de toutes les cellules 30 sont électriquement connectées car les zones secondaires 82 ne sont pas jointives, laissant ainsi un contact électrique 42 entre ces cellules 30 après retrait du masque 8. Ce contact électrique 42 entre les cellules 30 a pour but de faciliter l'étape d'électrodéposition de la deuxième couche 5, car il suffit de polariser l'une des cellules 30 pour polariser de manière équivalente toutes les cellules 30.

En partant de la première couche 4 avec les trous 31 et les bandes de séparation 32, on réalise les étapes suivantes pour déposer les deuxième et troisième couches 5, 6, tout en assurant l'interconnexion entre les deux cellules 30 :
- on dépose par électrodéposition la deuxième couche 5 sur les parties non trouées de la première couche 4 (figure 10b et figure 12d), cette étape est facilitée car les premières couches 4 de toutes les cellules sont connectées entre elles électriquement grâce au contact électrique 42 ;
- on grave la première et la deuxième couche 4, 5 pour couper le contact électrique 42 entre les cellules 30, au niveau des extrémités des bandes de séparation 32 (figure 12e) ;
- on grave directement, notamment selon une technique dite de « scribing », la deuxième couche 5 (figures 10c, 12f et 12g), sur une ou plusieurs cellules 30, le long d'une bordure de la bande de séparation 32 concernée (bordure de gauche sur les figures 10c, 12f et 12g), sur une largeur donnée, mettant à nu des bandes 40 de la première couche 4 des cellules 30, ces bandes 40 étant parallèles aux bandes de séparation 32 (sur la figure 12f seules les bandes 40 entre les cellules de gauche et de droite sont illustrées, mais pas celles entre les cellules du haut et du bas) ;

- on dépose par évaporation la troisième couche 6 qui recouvre ainsi de manière uniforme la deuxième couche 5, les bandes 40 à nu de la première couche 4 de la première cellule 30, les trous 31 et les bandes de séparation 32 (figures 10d, 12h et 12i - la troisième couche 6 n'étant pas illustrée dans les trous 31 sur les figures 12h à 12k pour des raisons de clarté), de sorte que l'on réalise un contact électrique entre les bande 40 et la troisième couche 6 avec toutefois des court-circuit au niveau des cellules 30 ;
- on grave directement, notamment selon une technique dite de « scribing », la troisième couche 6 pour couper les court-circuit précités établi dans les cellules 30 sur leurs bandes 40 respectives (figures 10e, 12j et 12k), en gravant des bandes 60 sur cette troisième couche 6 de façon à mettre à nu une partie des bandes 40 de la première couche 4 des cellules 30 (coupant le contact électrique entre la première et la troisième couches 4, 6 au sein de la même cellule 30), tout en maintenant un contact électrique entre les bandes 40 d'une cellule et la troisième couche 6 de la cellule adjacente, établissant ainsi la connexion en série entre les cellules 30.

Il est à noter que, si on dépose la deuxième couche 5 par évaporation ou pulvérisation (à la place du dépôt par électrodéposition illustré sur les figures 10b et 12d), il n'est pas nécessaire d'assurer le contact électrique 42 préalable entre les cellules 30. Ainsi, dans ce cas de figure, les zones secondaires 82 du masque 8 peuvent être jointives.

La figure 11 illustre un perfectionnement des étapes de la figure 8, en portant sur des sous-étapes destinées à assurer l'interconnexion entre deux cellules 30 adjacentes, autrement dit la connexion électrique entre la première couche 4 d'une cellule 30 et la troisième couche 6 d'une cellule 30 adjacente.

La figure 11a illustre un substrat 2 sur lequel a été déposé un masque 8 en positif présentant des zones principales 81 et secondaires 82, et sur lequel a ensuite été déposé de manière uniforme, par pulvérisation ou par évaporation, une première couche 4.

En partant de la situation de la figure 11a, on réalise les étapes suivantes pour déposer les deuxième et troisième couches 5, 6, tout en assurant l'interconnexion entre deux cellules 30 :
- on dépose de manière uniforme, par pulvérisation ou par évaporation, une deuxième couche 5 (figure 11 b) ;
- on dépose de manière uniforme, par pulvérisation ou par évaporation, une troisième couche 6 (figure 11c) ;
- on élimine chimiquement le masque 8, laissant sur le substrat 2 uniquement les première, deuxième et troisième couches 4, 5, 6 présentant les trous 31 en positif des zones principales 81 et les bandes de séparation 32 en positif des zones secondaires 82 (figure 11d) ;
- on grave directement, notamment selon une technique dite de « scribing », la deuxième et la troisième couches 5, 6 le long d'une bordure de la bande de séparation 32, sur une largeur donnée (bordure de gauche sur la figure 11e), afin de mettre à nu une bande 41 de la première couche 4 de la première cellule 30, cette bande 41 étant parallèle à la bande de séparation 32 (figure 11 e) ;
- on dispose dans la bande de séparation 32 un contacteur électrique 33 qui comprend une partie conductrice 34 établissant le contact entre la bande 41 et la troisième couche 6 de la seconde cellule 30 et une partie isolante 35 intercalée entre les premières couches 4 des deux cellules 30, établissant ainsi la connexion en série entre les deux cellules 30.

La suite de la description porte sur la conformation géométrique des trous 31, en référence notamment aux figures 2a, 2b, 3a et 3b.

De manière avantageuse, les trous 31 sont répartis sur la surface de chaque cellule 30 selon un pavage virtuel composé d'une pluralité d'unités élémentaires photovoltaïques juxtaposées sans vide et sans empiétement pour définir la cellule 30 correspondante. Le principe est ainsi de définir un ou plusieurs motifs de base, définissant une ou plusieurs unités élémentaires, qui seront répétés pour paver complètement chaque cellule 30, de sorte qu'en gérant la transparence au niveau microscopique (avec les unités élémentaires), on gère la transparence au niveau macroscopique (au niveau de la cellule).

Chaque unité élémentaire se présente sous la forme d'une portion géométrique du film photovoltaïque 3, dont les des dimensions dans le plan principal sont comprises entre 15 nanomètres et 800 micromètres, délimitée par un contour virtuel (le contour du motif) et à laquelle est associé au moins un trou ménagé en tout ou partie à l'intérieur dudit contour (la surface trouée dans l'unité élémentaire définissant microscopiquement la surface trouée de la cellule), chaque trou étant associé à une unique unité élémentaire.

Chaque unité élémentaire présente une surface trouée, correspondant à la surface du ou des trous associés à l'unité élémentaire dans le plan principal, qui est comprise entre 10 et 90% de la surface totale de l'unité élémentaire dans ce même plan principal, de préférence entre 30 et 70%.

En travaillant avec un masque 8, on gère le pavage des unités élémentaires en gérant le pavage des zones principales 81 décrites ci-dessus.

Les figures 2a, 2b, 3a et 3b illustrent des masques 8 en positif présentant des zones principales 81 de forme circulaire (d'autres formes étant bien entendu envisageables) réparties selon des pavages prédéfinies.

Avec un masque 8 en positif, les zones principales 81 du masque 8 sont réparties sur la surface de chaque cellule 30 selon un pavage virtuel composé d'une pluralité de motifs juxtaposés sans vide et sans empiétement, chaque motif étant délimité par un contour virtuel auquel est associé au moins une zone principale 81 située en tout ou partie à l'intérieur dudit contour.

Le motif forme le plus petit élément géométrique permettant de construire le masque 8 d'échelle macroscopique par application d'un algorithme donné à ce motif (essentiellement translation selon deux directions, symétrie et rotation), tout en intégrant que le motif doit de préférence offrir le moins d'interaction avec les mécanismes physiologiques de la vision, et contribuer à la meilleure uniformité perçue du dispositif photovoltaïque et au meilleur confort visuel.

Il est en outre important de noter la définition suivante : la résolution du masque 8 caractérise la plus petite dimension du motif de base. Or la résolution n'a pas d'impact sur le niveau de transparence ou sur l'efficacité énergétique du film photovoltaïque, mais elle peut influer sur la façon dont l'oeil perçoit la transparence de ce film photovoltaïque et cette résolution constitue donc un facteur potentiel de confort ou d'inconfort visuel. En particulier, la résolution joue un rôle sur l'uniformité perçue du film photovoltaïque, et plus la résolution sera fine, plus la perception d'uniformité sera importante.

Dans la mise en oeuvre d'un procédé d'impression du masque 8, il est à noter que la résolution du masque 8 est tout de même limitée vers le bas par la technique d'impression employée. À titre d'illustration, si le procédé d'impression présente une résolution intrinsèque de 300 points par pouce pour dessiner le motif, cela signifie que le point de base imprimé est de l'ordre de 85 micromètres au minimum, de sorte qu'un tel procédé d'impression ne permettra pas de dessiner des motifs de taille inférieure à 100 micromètres. La résolution intrinsèque du procédé d'impression du masque 8 conditionne donc automatiquement la résolution finale du masque 8.

Dans un premier mode de réalisation du masque 8 illustré sur la figure 2a, on met en oeuvre un pavage périodique dit orthogonal ou carré, à partir d'un motif consistant en un disque concentrique (la zone principale 81) centré à l'intérieur d'un carré (le contour virtuel) ; le motif étant répété par translation le long des axes parallèles aux côtés du carré, créant ainsi des alignements des disques selon ces deux axes.

Dans un deuxième mode de réalisation du masque 8 illustré sur la figure 2b, on met en oeuvre un pavage périodique dit en quinconce ou en nid d'abeille, à partir d'un motif consistant en un disque concentrique (la zone principale 81) centré à l'intérieur d'un hexagone (le contour virtuel) ; le motif étant répété par translation parallèlement aux côtés de l'hexagone de sorte que les disques 81 d'une ligne (ou d'une colonne) sont placés en quinconce par rapport à ceux de la ligne (ou colonne) précédente.

Afin d'éviter d'avoir des motifs périodiques qui pourrait amoindrir le confort visuel du film photovoltaïque, il est envisageable de procéder avec un pavage non périodique du plan.

Dans un troisième mode de réalisation du masque 8 illustré sur la figure 3a, on met en oeuvre un pavage non périodique dit « pinwheel ». Ce pavage est réalisé à partir d'un motif composé d'un disque concentrique (la zone principale 81) situé à l'intérieur triangle rectangle (le contour virtuel) dont les cathètes sont dans un rapport de deux. Le pavage de « pinwheel », développé par le mathématicien britannique John Conway est basé sur une décomposition du triangle considéré en cinq triangles homothétiques à partir d'un triangle d'origine, par la mise en oeuvre de symétries, de translations et de rotations.

Dans un quatrième mode de réalisation du masque 8 illustré sur la figure 3b, on met en oeuvre un pavage non périodique du type aléatoire.

Ce pavage aléatoire constitue une variante des pavages périodiques exposés ci-dessus, avec l'objectif de rompre la périodicité, c'est-à-dire de ne pas obtenir des lignes de disques parallèles et régulièrement réparties ; le principe étant de brouiller la répartition des disques afin que l'oeil ne puisse pas s'accrocher sur une structure régulière quelconque.

Cependant, ce pavage aléatoire doit respecter un certain nombre de contraintes et de propriétés statistiques.

La première contrainte est que le pavage des motifs doit assurer un niveau de transparence constant indépendant de l'échelle considérée (sauf, bien entendu, à descendre en dessous du pas de base). En d'autres termes, ce pavage aléatoire ne doit pas conduire à obtenir des zones transparentes ou opaques trop importantes afin que le rendu global soit relativement uniforme.

La seconde contrainte est de respecter une distance minimale entre deux disques 81 voisins, de sorte que l'on puisse garantir un dépôt de la première couche 4 d'une largeur minimale (fonction des capacités de la technologie d'impression du masque 8 et/ou de dépôt des couches minces) entre deux trous 31.

De manière générale, d'autres formes des zones principales 81 peuvent être envisagées, pas uniquement la forme en disque, comme par exemple des formes en ellipse, rectangle, etc. L'emploi de ces autres formes pourrait se révéler intéressant en particulier pour les pavages non périodiques, où l'orientation du motif de base varie. À titre d'exemple, une zone principale en ellipse dans un pavage « pinwheel » permettrait d'accéder à des niveaux de transparence supérieurs et contribuerait à brouiller visuellement le motif par variation de l'angle de l'axe focal de l'ellipse avec l'horizontale.

En outre, il est envisageable de faire varier les dimensions des zones principales 81 sur le substrat, afin d'offrir un effet de dégradé, avec par exemple une transparence qui augmente graduellement de bas en haut ou de droite à gauche sur le substrat.

Bien entendu l'exemple de mise en oeuvre évoqué ci-dessus ne présente aucun caractère limitatif et d'autres améliorations et détails peuvent être apportés au dispositif photovoltaïque selon l'invention, sans pour autant sortir du cadre de l'invention où d'autres formes de motif peuvent par exemple être réalisées.

## Revendications

1. Procédé de fabrication d'un dispositif photovoltaïque (1) à couches minces, comprenant les étapes suivantes :
- on fournit un substrat (2) ;
- on pose un film photovoltaïque (3) sur ledit substrat (2) par la superposition de couches comprenant, dans cet ordre, au moins une première couche (4) conductrice formant un contact électrique arrière, une deuxième couche (5) photo-active absorbant dans le spectre solaire à base de matériau inorganique, et une troisième couche (6) en matériau conducteur transparent formant un contact électrique avant ;
- on divise le film photovoltaïque (3) en une pluralité de cellules (30) photovoltaïques individuelles et interconnectées, chaque cellule (30) étant connectée en série ou en parallèle avec une ou plusieurs cellules (30) adjacentes et isolée électriquement des autres cellules (30) adjacentes, dans lequel on ménage, au moment de la pose du film photovoltaïque (3), une pluralité de trous (31) individuels traversant au moins les première et deuxième couches (4, 5) du film photovoltaïque (3) dans chaque cellule (30), par application d'un masque (8) selon un procédé d'impression, notamment du type impression numérique par jet de matière, flexographie, sérigraphie, ou tampographie, ledit masque (8) présentant des zones principales (81) définissant un pochoir en positif desdits trous (31) ;
ledit procédé étant **caractérisé en ce qu'**il comprend les étapes suivantes :
- on dépose le masque (8) directement sur le substrat (2), ledit masque (8) formant un pochoir en positif des trous (31) ;
- on dépose de manière uniforme une première couche (4) conductrice qui recouvre le masque (8) et les zones nues du substrat (2).

2. Procédé selon la revendication 1, dans lequel, à la suite du dépôt de la première couche (4) conductrice, on élimine le masque (8), laissant sur le substrat (2) uniquement la première couche (4) conductrice présentant des trous(31) en positif du masque (8).

3. Procédé selon la revendication 2, dans lequel on effectue les étapes suivantes :
- on dépose la deuxième couche (5) sur les parties non trouées de la première couche (4) conductrice, de préférence par électrodéposition ;
- on dépose la troisième couche (6), de préférence par évaporation.

4. Procédé selon la revendication 1, dans lequel, à la suite du dépôt de la première couche (4) conductrice :
- on dépose de manière uniforme la deuxième couche (5) qui recouvre la première couche (4) conductrice ;
- on dépose de manière uniforme la troisième couche (6) qui recouvre la deuxième couche (5) ;
- on élimine le masque (8), laissant sur le substrat (2) le film photovoltaïque (3) présentant des trous (31) en positif du masque (8).

5. Procédé selon l'une quelconque des revendications précédentes, dans lequel le masque (8) présente des zones secondaires (82) définissant un positif ou un négatif de bandes de séparation (32) entre les cellules (30) du film photovoltaïque (3).

6. Procédé selon l'une quelconque des revendications précédentes, dans lequel les trous (1) sont ménagés en respectant les caractéristiques géométriques suivantes :
- chaque trou (31) présente des dimensions dans le plan principal comprises entre 10 nanomètres et 400 micromètres,
- chaque trou (31) est distant du trou (31) adjacent le plus proche d'une distance comprise entre 5 nanomètres et 400 micromètres,
- chaque cellule (30) présente une surface trouée, correspondant à la surface des trous (31) disposés dans ladite cellule (30) dans le plan principal, qui est comprise entre 10 et 90% de la surface totale de la cellule (30) dans ce même plan principal, de préférence entre 30 et 70%.

7. Procédé selon l'une quelconque des revendications précédentes, dans lequel la première couche (4) est une couche métallique opaque.

## Patentansprüche

1. Verfahren zum Herstellen einer fotovoltaischen Vorrichtung (1) mit Dünnschichten, das die folgenden Schritte umfasst:
- Liefern eines Substrats (2);
- Ablegen einer fotovoltaischen Folie (3) auf dem Substrat (2) durch die Überlagerung von Schichten, die in dieser Reihenfolge mindestens eine erste leitende Schicht (4), die einen hinteren elektrischen Kontakt bildet, eine zweite fotoaktive Schicht (5), die in dem Solarspektrum absorbiert, auf der Basis anorganischen Werkstoffs, und eine dritte Schicht (6) aus durchsichtigem leitendem Werkstoff, die einen vorderen elektrischen Kontakt bildet, umfasst;
- Teilen der fotovoltaischen Folie (3) in eine Mehrzahl einzelner und untereinander verbundener fotovoltaischer Zellen (30), wobei jede Zelle (30) mit einer oder mehreren benachbarten und von den anderen benachbarten Zellen (30) galvanisch isolierten Zellen (30) in Reihe oder parallel geschaltet sind,
wobei man im Augenblick des Ablegens der fotovoltaischen Folie (3) eine Mehrzahl einzelner Löcher (31), die mindestens die erste und zweite Schicht (4, 5) der fotovoltaischen Folie (3) in jeder Zelle (30) durchquert, durch Aufbringen einer Maske (8) gemäß einem Druckverfahren, insbesondere des digitalen Typs, durch Materialstrahl, Flexografie, Serigrafie oder Tampondruck einrichtet, wobei die Maske (8) Hauptzonen (81) aufweist, die eine Positiv-Schablone der Löcher (31) definieren;
wobei das Verfahren **dadurch gekennzeichnet ist, dass** es die folgenden Schritte umfasst:
- Ablagern der Maske (8) direkt auf dem Substrat (2), wobei die Maske (8) eine Positiv-Schablone der Löcher (31) bildet;
- gleichmäßiges Ablagern einer ersten leitenden Schicht (4), die die Maske (8) und die bloßen Zonen des Substrats (2) abdeckt.

2. Verfahren nach Anspruch 1, wobei man, im Anschluss an das Ablagern der ersten leitenden Schicht (4) die Maske (8) eliminiert, indem man auf dem Substrat (2) nur die erste leitende Schicht (4), die Positiv-Löcher (31) der Maske (8) aufweist, hinterlässt.

3. Verfahren nach Anspruch 2, wobei man die folgenden Schritte ausführt:
- Ablagern der zweiten Schicht (5) auf den nicht gelochten Teilen der ersten leitenden Schicht (4), vorzugsweise durch Aufmetallisieren;
- Ablagern der dritten Schicht (6), vorzugsweise durch Verdampfen.

4. Verfahren nach Anspruch 1, wobei man im Anschluss an das Ablagern der ersten leitenden Schicht (4):
- gleichmäßig die zweite Schicht (5) ablagert, die die erste leitende Schicht (4) abdeckt;
- gleichmäßig die dritte Schicht (6) ablagert, die die zweite Schicht (5) abdeckt;
- die Maske (8) eliminiert, indem man auf dem Substrat (2) die fotovoltaische Folie (3), die die Positiv-Löcher (31) der Maske (8) aufweist, hinterlässt.

5. Verfahren nach einem der vorhergehenden Ansprüche, wobei die Maske (8) Sekundärzonen (82) aufweist, die Positiv- oder Negativ-Trennbänder (32) zwischen den Zellen (30) der fotovoltaischen Folie (3) definieren.

6. Verfahren nach einem der vorhergehenden Ansprüche, wobei die Löcher (1) unter Einhaltung der folgenden geometrischen Merkmale eingerichtet werden:
- jedes Loch (31) weist Maße in der Hauptebene zwischen 10 Nanometer und 400 Mikrometer auf,
- jedes Loch (31) ist von dem nächst gelegenen benachbarten Loch (31) um eine Entfernung entfernt, die zwischen 5 Nanometer und 400 Mikrometer liegt,
- jede Zelle (30) weist eine gelochte Oberfläche auf, die der Oberfläche der Löcher (31) entspricht, die in der Zelle (30) in der Hauptebene angeordnet sind, die zwischen 10 und 90 % der gesamten Oberfläche der Zelle (30) in derselben Hauptebene liegt, vorzugsweise zwischen 30 und 70 %.

7. Verfahren nach einem der vorhergehenden Ansprüche, wobei die erste Schicht (4) eine undurchsichtige metallische Schicht ist.

## Claims

1. A method for manufacturing a thin-layer photovoltaic device (11), comprising the following steps :
- providing a substrate (2) ;
- laying a photovoltaic film (3) on said substrate (2) by the superposition of layers comprising, in this order, at least a first conductive layer (4) forming a rear electrical contact, a second photoactive layer (5) absorbent in the solar spectrum based in inorganic material, and a third layer (6) made of transparent conductive material forming a front electrical contact;
- dividing the photovoltaic film (3) into a plurality of individual interconnected photovoltaic cells (30), each cell (30) being connected in series or in parallel with one or more adjacent cell(s) (30) and electrically isolated from the other adjacent cells (30),
wherein, at the moment of laying the photovoltaic film (3), a plurality of individual holes (31), passing through at least the first and second layers (4, 5) of the photovoltaic film (3) in each cell (30), are arranged by applying a mask (8) according to a printing method, in particular of the material jet, flexography, screen printing, or pad printing digital print type, said mask (8) having main areas (81) defining a positive stencil of said holes (31);
said method being **characterized in that** it comprises the following steps:
- depositing the mask (8) directly on the substrate (2), said mask (8) forming a positive stencil of the holes (31);
- depositing uniformly a first conductive layer (4) which covers the mask (8) and the bare areas of the substrate (2).

2. The method according to claim 1, wherein, following the deposition of the first conductive layer (4), the mask (8) is removed, leaving on the substrate (2) only the first conductive layer (4) having positive holes (31) of the mask (8).

3. The method according to claim 2, wherein the following steps are performed:
- depositing the second layer (5) on the non-perforated portions of the first conductive layer (4), preferably by electrodeposition;
- depositing the third layer (6), preferably by evaporation.

4. The method according to claim 1, wherein, following the deposition of the first conductive layer (4):
- depositing uniformly the second layer (5) which covers the first conductive layer (4);
- depositing uniformly the third layer (6) which covers the second layer (5);
- removing the mask (8), leaving on the substrate (2) the photovoltaic film (3) having positive holes (31) of the mask (8).

5. The method according to any one of the preceding claims, wherein the mask (8) has secondary areas (82) defining a positive or a negative of separation strips (32) between the cells (30) of the photovoltaic film (3).

6. The method according to any one of the preceding claims, wherein the holes (1) are arranged by respecting the following geometrical characteristics:
- each hole (31) has dimensions in the main plane which are comprised between 10 nanometers and 400 micrometers,
- each hole (31) is remote from the nearest adjacent hole (31) by a distance comprised between 5 nanometers and 400 micrometers,
- each cell (30) has a perforated surface, corresponding to the surface of the holes (31) disposed in said cell (30) in the main plane, which is comprised between 10 and 90% of the total surface of the cell (30) in this same main plane, preferably between 30 and 70%.

7. The method according to any one of the preceding claims, wherein the first layer (4) is an opaque metal layer.
